(19) Europäisches Patentamt

European Patent Office

Office européen des brevets

(11) **EP 0 901 637 B1**

(12) **FASCICULE DE BREVET EUROPEEN**

(45) Date de publication et mention
de la délivrance du brevet:
**20.11.2002 Bulletin 2002/47**

(51) Int Cl.⁷: **G01R 31/28**

(86) Numéro de dépôt international:
**PCT/FR97/00908**

(21) Numéro de dépôt: **97925127.9**

(22) Date de dépôt: **23.05.1997**

(87) Numéro de publication internationale:
**WO 97/045748 (04.12.1997 Gazette 1997/52)**

(54) **PROCEDE DE TEST DE COMPOSANTS ELECTRONIQUES**

TESTVERFAHREN FÜR ELEKTRONISCHE BAUTEILE

METHOD FOR TESTING ELECTRONIC COMPONENTS

(84) Etats contractants désignés:
**DE FI FR GB IE IT SE**

(30) Priorité: **29.05.1996 FR 9606611**

(43) Date de publication de la demande:
**17.03.1999 Bulletin 1999/11**

(73) Titulaire: **Softlink**
**91410 Dourdan (FR)**

(72) Inventeur: **LEJEUNE, Philippe**
**F-28630 Bretigny (FR)**

(74) Mandataire: **Schmit, Christian Norbert Marie et al**
**Cabinet Christian Schmit et Associes,**
**8, place du Ponceau**
**95000 Cergy (FR)**

(56) Documents cités:
**EP-A- 0 171 322        EP-A- 0 646 802**
**DE-A- 3 530 308        US-A- 4 977 531**

**Description**

L'invention concerne les tests de composants électroniques.

En sortie de fabrication, les composants électroniques semi-conducteurs sont testés par un appareil de test, demeurés réunis sur plaquette ou gaufrette ("wafer"), et/ou en l'état de composants unitaires, avec ou sans boîtier, éventuellement présentés en réglettes.

L'appareil de test comprend des électrodes agencées respectivement pour venir au contact de zones (ou plages) conductrices du composant. Des signaux sont appliqués à ces électrodes, et captés par elles, grâce à une interface configurée par des moyens de test de l'appareil.

L'appareil de test comprend un ensemble de modules électroniques et de logiciels, dont la fonction générale est de comparer chaque valeur mesurée à une valeur ou un intervalle de référence (ou domaine de validité), en vue de décider globalement si le composant est bon ou mauvais. Des décisions plus fines peuvent être prises, par exemple dans le cas où l'on fabrique ensemble des composants semblables, mais garantis avec des fourchettes de tolérance différentes.

Plus précisément, les logiciels peuvent être décomposés en une bibliothèque d'outils, une définition de constantes, variables et tableaux de données (multiplets), notamment pour les intervalles de référence, une séquence de tests élémentaires pour l'acquisition des mesures et leurs comparaisons aux intervalles de référence, et un mécanisme de décision finale.

Les tests élémentaires de la séquence sont stockés dans une mémoire des moyens de test et subdivisés en étapes gérées par un séquenceur. Ainsi, chaque test comprend généralement les étapes suivantes:

a) configurer l'interface en vue de l'exécution d'un test élémentaire choisi, (cette étape consiste à désigner sélectivement des électrodes sur lesquelles doivent être appliqués des signaux électriques choisis).

b) après application du signal (ou des signaux) électrique(s) choisi(s) pour le test élémentaire, attendre pendant un premier délai nominal de stabilisation fixé (ou au moins le plus long des premiers délais de stabilisation) correspondant au test,

c) capter sélectivement sur des électrodes désignées, la (ou les) grandeurs(s) électrique(s) désignée(s) par le test élémentaire et représentant les réponses du composant aux signaux électriques choisis,

d) éventuellement attendre pendant un second délai de mesure fixé (ou au moins le plus long des seconds délais de mesure) correspondant au test élémentaire, afin que la mesure de la grandeur électrique désignée soit stabilisée dans l'appareil de mesure,

e) lire la (ou les) mesure(s) de(s) grandeur(s) électrique(s) désignée(s) par le test élémentaire, et

f) comparer la grandeur électrique mesurée au domaine de validité correspondant au test élémentaire.

Un tel procédé est par exemple décrit dans le document DE-A-35 30 308.

Comme le nombre d'opérations de test à effectuer est généralement très élevé, l'attente globale qui résulte du cumul des premières et éventuelles secondes phases d'attente (ou délais) est importante (chaque phase d'attente peut durer au moins quelques millisecondes). Ceci constitue un problème majeur, dans une industrie constamment à la recherche d'une meilleure productivité.

L'attente est d'ailleurs aggravée par le fait que la durée de chaque phase élémentaire d'attente d'une opération de test est plutôt fixée par excès, car la qualité prime encore sur la productivité. Cette précaution permet d'englober la dispersion des lots.

En conséquence, un but de l'invention est de permettre la réduction des durées des phases d'attente des appareils de test de composants électroniques du type décrit en introduction.

L'invention propose à cet effet un procédé de test de composants électroniques dans lequel

- on soumet à une date initiale des électrodes de ces composants à des potentiels électriques,
- on mesure, à une date de mesure, des valeurs de potentiels établis à des bornes de ces composants, et
- on compare ces valeurs mesurées à des valeurs types, pour accepter ou rejeter les composants en fonction de cette comparaison,

et, pour la comparaison, dans une phase d'apprentissage préalable,

- on détermine, à une date nominale correspondant à une durée nominale d'attente après cette date initiale, pour un lot de composants acceptables et pour un test donné, une image statistique nominale des valeurs mesurées,
- on détermine pour ce lot acceptable, à au moins une date intermédiaire, antérieure ou postérieure à la fin de la durée nominale d'attente, une image statistique intermédiaire des valeurs mesurées,
- caractérisé en ce que on choisit une date intermédiaire la plus précoce possible pendant la durée de mesure en comparant, au moyen d'un critère, les images statistiques nominale et intermédiaire des valeurs mesurées, et
- on retient comme date de mesure du test la date intermédiaire la plus précoce possible.

Dans l'invention, la durée d'attente est la durée nominale au bout de laquelle le potentiel est normalement stabilisé aux bornes du composant. Cette durée est en pratique indiquée dans les spécifications techniques du composant. Un composant acceptable, dit encore à accepter, est un composant dont on sait par ailleurs qu'il est acceptable. Un tel composant peut être identifié individuellement. D'une façon plus générale, un composant à accepter est virtuel: ses caractéristiques peuvent être les résultats de mesures statistique effectuées sur un ensemble de composants jugés individuellement acceptables. Ou encore les caractéristiques du composant à accepter sont les résultats de mesures statistiques effectuées sur un ensemble de composants en ayant éliminé des mesures aberrantes.

Dans l'invention, on s'est ainsi rendu compte que la meilleure méthode pour rechercher la date la plus précoce consistait à faire une étude statistique sur des échantillons pour un test donné, à une date donnée de mesure, et à rechercher pour une autre date de mesure une répartition statistique compatible.

Ainsi, dans un mode de réalisation préféré, sur une population donnée, c'est-à-dire pour des échantillons donnés pour un test donné, à une date donnée de mesure, on calcule d'une part une moyenne des mesures, notée M, et d'autre part un écart type des mesures noté S (comme sigma). on remarque déjà qu'on aurait pu choisir d'autres éléments statistiques comme la médiane, la moyenne du 1er, 2ème, 3ème ou 4ème quartile, les écarts entre ces moyennes ou autre. Pour l'instant on retient pour ces éléments utiles la moyenne et l'écart type.

Ensuite pour les mêmes échantillons et pour un même test, mais pour une autre date de mesure plus précoce (ou plus tardive) dite intermédiaire, on effectue des mesures et on calcule les mêmes éléments, une moyenne M' et un écart type S'.

On définit en plus un critère d'appréciation noté CP. Dans un exemple, ce critère d'appréciation CP égale le rapport d'une différence de limites à S. Dans cet exemple, la différence des limites est donnée par une tolérance fabricant To, et CP=To/S. La différence est par exemple, pour une mesure pour laquelle on attend un résultat de 5 volts, un écart de plus ou moins 0,5 volts. La différence des limites est donc de To=1 volt dans ce cas. Si au lieu de mesurer des valeurs atteintes aux points de test (par exemple 5 volts), on mesure une différence entre une valeur atteinte et une valeur à atteindre, le résultat peut s'exprimer plus finement. Surtout dans ce cas, il devient semblable pour tous les tests différents, de sorte qu'un même procédé de sélection peut être utilisé.

On calcule dans l'invention, pour une autre date de mesure dite date intermédiaire, le résultat du même critère, par exemple CP'=To/S'. La tolérance fabricant reste la même. L'écart type a changé. Selon l'invention on a conçu que, pour une structure donnée d'échantillon, l'écart type S' et donc le critère CP' dépendent de la date à laquelle est faite la mesure. On a découvert dans l'invention que si on remontait dans le temps, l'écart type S' s'accroissait. Tout se passe comme si le temps qui restait à courir après la date intermédiaire apparaissait alors comme un phénomène de resserrement des caractéristiques statistiques. Tout se passe comme si le temps qui restait à courir avait un effet d'amortissement sur les mesures. Par exemple, un signal de sortie erratique à une date précoce T' devient un signal acceptable au bout d'une durée T suffisamment longue et en tout cas plus longue que T'.

Partant de là, dans l'invention on a eu l'idée pour définir la date T' la plus précoce, de retenir la date T' pour laquelle le critère CP' (ou l'écart type S') se trouverait dans une proportion donnée du critère CP de base (ou respectivement de l'écart type S de base). Dans un exemple, la proportion donnée est de 1%, 2% voire de 5%.

En d'autres termes, un lot de composants est testé avec des phases d'attente prédéfinies. Puis, on effectue le même test sur le même lot de composants, en réduisant le premier délai (phase de stabilisation avant capture). En fonction du résultat, soit on poursuit le test sur le même lot de composants, en réduisant de nouveau la phase d'attente, soit on considère que le ou les délais modifiés sont suffisamment petits pour que désormais ils servent de nouveaux délais pour les tests des composants à tester.

Dans un perfectionnement, dans une phase préparatoire on acquiert, ce qui est appelé par la suite valeur intermédiaire progressive, une valeur de mesure, par exemple d'un potentiel à une borne. Cette valeur intermédiaire est dite progressive parce que le potentiel à cette borne se modifie depuis une valeur de base, lors de l'application du signal électrique (généralement la valeur de base est O volt), jusqu'à une valeur stabilisée (généralement Vcc voire Vcc /2). Mais la mesure peut être tout aussi bien qu'une tension, un courant (les deux continus ou alternatifs), une fréquence, une température mesurée, ou le résultat d'un calcul ou autre. La progression de la valeur de ce potentiel est répétitive: son historique est toujours le même. Une valeur progressive est alors acquise à une date intermédiaire, avant la fin de la durée nominale d'attente. Cette valeur progressive peut être égale à la valeur stabilisée elle-même: dans ce cas la durée nominale d'attente prévue était tout simplement fixée par excès. Cette valeur progressive peut cependant être différente (en général inférieure) à la valeur stabilisée. Du fait de la répétitivité du phénomène, on est sûr que pour un composant l'historique sera le même.

Dans ce cas, dans l'invention, au couple durée nominale - valeur type on substitue le couple date intermédiaire - valeur type progressive ou intermédiaire. Le test consiste alors, sur un composant à tester, à mesurer précocement une valeur de potentiel à la date intermédiaire et à comparer cette valeur précoce mesurée à la valeur type progressive intermédiaire retenue sur un composant à accepter.

Si beaucoup de tensions à tester ou autres grandeurs électriques sont croissantes, passage de 0 volt à Vcc, d'autres tensions, ou autres grandeurs électriques, sont décroissantes. Le même principe s'applique néanmoins pour les bornes où ces potentiels sont rencontrés.

En outre, on a découvert dans l'invention deux phénomènes. Le premier phénomène est un phénomène de mesure tardive. Le second phénomène est un phénomène de fluctuation. En ce qui concerne le phénomène de mesure tardive, on s'est rendu compte que les spécifications imposées par le fabricant conduisaient quelques fois à retenir des durées nominales trop courtes. Avec l'invention, on a eu l'idée de déplacer la date de mesure, non plus antérieurement à la fin de la durée nominale, mais au contraire postérieurement. Il apparaît alors d'une manière inattendue que beaucoup de composants, qui étaient écartés du fait d'un test mal évalué selon les spécifications, sont alors considérés comme bons puisque le potentiel mesuré a atteint, après la durée nominale d'attente (avec un retard tolérable toutefois), la valeur stabilisée attendue. Dans ce cas le rallongement de la durée du test, contrairement à ce qui se passait dans l'état de la technique, augmente le rendement (nombre de pièces bonnes par heure), puisque plus de composants sont en définitive acceptés.

Le fait de faire varier selon l'invention la date de mesure, entre la date d'application des signaux électriques de test et la fin de la durée nominale a conduit naturellement à relever l'historique de l'établissement des potentiels aux bornes testées. Cet historique est une information précieuse pour le fabricant qui, avant l'invention, ne disposait que de résultats de simulations. De plus la mesure de cet historique fait apparaître l'existence de potentiels fluctuants, jamais correctement stabilisés. Pour ces derniers, il n'est pas vraiment possible de trouver un critère de réduction de la durée nominale d'attente. On ne la réduit donc pas. Cependant, on sait que le potentiel est fluctuant alors que ceci n'était pas connu antérieurement.

La substitution de couple durée nominale - valeur type par le couple date intermédiaire - valeur intermédiaire progressive revient à devoir mesurer une valeur précoce qui soit compatible avec la valeur progressive. Afin de présenter des résultats de mesure d'une manière cohérente avec des tests anciens (effectués avant l'invention), on choisit en plus d'éditer une valeur de mesure qui n'est pas la valeur précoce mesurée réellement, mais une valeur fictive stabilisée, à laquelle on serait parvenu si on avait attendu jusqu'à la fin de la durée nominale. Dans ce cas, un générateur de fonction permet de déterminer une fonction à appliquer à la valeur de chaque grandeur électrique mesurée avec les nouveaux délais, afin que chacune d'entre elles soit ramenée à la valeur qu'elle aurait avec les délais initialement prévus.

La réduction de l'attente, qui s'effectue automatiquement, de préférence de façon dichotomique ou pas à pas, permet de gagner du temps et par conséquent de réduire les coûts de production des composants électroniques. Une réduction dichotomique est une réduction dans laquelle de préférence la durée des pas va en s'amenuisant. La réduction est exprimée en pourcentage de la durée nominale. Des pas de 5% sont prévus dans la réduction pas à pas. Des pas plus faibles peuvent être envisagés dans la réduction dichotomique.

Les machines de test existantes comportent des moyens pour provoquer la mesure au bout d'une seule durée d'attente nominale. Ces machines étant commandées par des programmes et ceux-ci étant paramétrables, on trouve par exemple dans ces programmes des instructions du type: "WAIT 100". Ceci veut dire que la mesure doit être faite 100 ms après l'application du signal électrique de test. De manière à mettre en oeuvre simplement l'invention, ces instructions sont remplacées dans ces programmes par des appels à des sous programmes qui vont avoir pour effet 1), au moment de la caractérisation du test, de réitérer les mesures avec des durées d'attente réduites petit à petit, et 2), au moment des tests, de remplacer la valeur initiale (100) par une valeur correspondant à la date intermédiaire déterminée.

Il est cependant envisagé que les machines de test futures puissent être reliées à des dispositifs de mesure, en une passe, de l'historique entier du signal présent sur une borne. Il suffit simplement de relier leur entrée de signal à un échantillonneur bloqueur rapide et à un convertisseur analogique numérique lui même relié à un processeur de signal numérique qui mémorise en une fois toutes les mesures effectuées. La réduction pas à pas ou progressive n'est donc pas essentielle dans l'invention, bien qu'elle en soit une forme préférée.

Selon une autre caractéristique de l'invention, l'appareil de test peut comprendre des moyens capables d'altérer la phase de comparaison du séquenceur pour que l'on opère en permanence avec la fonction, déterminée par le générateur de fonction. L'outil est alors mis "hors service", dans la mesure où il ne modifie plus les phases d'attente, et laisse, par conséquent, le séquenceur gérer les étapes.

Dans un mode de réalisation simplifié de l'outil, les moyens de traitement opèrent par réduction progressive du (ou des) second(s) délai(s) de mesure, et seulement de celui-ci (ou ceux-ci), jusqu'à satisfaction du critère de fin ou d'appréciation.

Dans un autre mode de réalisation de l'outil, les moyens de traitement opèrent de façon répétitive par réduction du (ou des) second(s) délai(s) de mesure, puis réduction progressive du premier délai de stabilisation, jusqu'à satisfaction du critère de fin.

Selon encore une autre caractéristique de l'invention, les moyens de traitement comprennent des moyens de filtrage propres à éliminer des mesures de grandeurs électriques aberrantes relativement à leurs domaines de validité respectifs, ce qui permet d'améliorer les résultats.

préférentiellement, les moyens de traitement comprennent des moyens d'adaptation propres à fixer un premier délai de stabilisation définitif compris entre le nouveau premier délai de stabilisation déterminé et le premier délai de stabilisation initial en fonction de la comparaison entre ledit seuil prédéterminé et la moyenne effectuée sur les résultats des comparaisons effectuées sur la série de composants électroniques.

Ainsi, afin de conserver le rendement de la production (rapport entre le nombre de composants jugés bons et le nombre de composants testés) au dessus d'un seuil modifiable, ou de le modifier en raison de fourchettes de tolérances différentes selon les séries de composants, on peut décider de choisir des délais d'attente plus grands, ou plus petits, que ceux déterminés lors des réductions successives.

Dans la description qui suit, faite à titre d'exemple, on se réfère aux dessins annexés, sur lesquels :

- la figure 1 est un diagramme bloc fonctionnel d'un outil d'aide selon l'invention et de l'appareil de test associé ;
- la figure 2 est un algorithme illustrant un mode de fonctionnement général de l'outil et de l'appareil de test de la figure 1 ;
- les figures 3a et 3b sont des diagrammes illustrant l'évolution d'une grandeur électrique mesurée (GEM) en fonction du délai d'attente pour effectuer la mesure ;
- les figures 3c à 3e illustrent le procédé de l'invention ;
- la figure 4 est un algorithme illustrant un mode d'apprentissage de l'outil et de l'appareil de test de la figure 1, et
- la figure 5 est un algorithme illustrant un mode de fonctionnement de l'appareil de test et de l'outil après apprentissage.

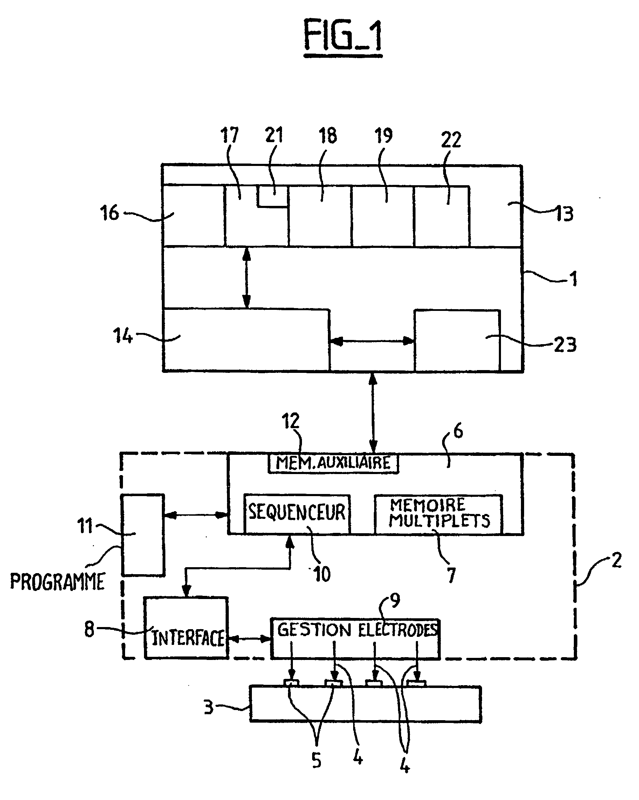

On se réfère tout d'abord à la figure 1 pour décrire un mode de réalisation préféré de l'outil d'aide 1 selon l'invention, lequel est destiné à fonctionner en coopération avec un appareil de test 2 (en pointillé).

Cet appareil de test 2 est destiné à tester le fonctionnement de composants électroniques 3. Pour ce faire, l'appareil de test 2 comprend une multiplicité d'électrodes 4 destinées à établir respectivement des contacts mécaniques sur des zones conductrices 5 du composant électronique à tester. Ces zones conductrices sont, lorsqu'il s'agit par exemple d'une puce électronique, les broches de connexion formant broches d'alimentation et broches d'entrée ou de sortie de signaux électriques.

Un appareil de test de ce type a donc pour fonction de tester toutes les fonctions offertes par un composant électronique. Chaque zone conductrice doit, par conséquent, être testée soit séparément, soit en combinaison avec une ou plusieurs autres zones conductrices.

Afin de pouvoir tester les zones conductrices 5 du composant 3, l'appareil de test 2 comprend des moyens de test 6 qui comportent une mémoire 7 dans laquelle se trouve stockée une pluralité de multiplets de paramètres de configuration formant respectivement des tests élémentaires. Un test complet de composant comprend généralement une succession de tests élémentaires différents.

Chaque multiplet comprend au moins une désignation d'électrode sur laquelle un signal électrique SE doit être appliqué, la valeur dudit signal électrique SE à appliquer, la désignation d'au moins une électrode sur laquelle une grandeur électrique, formant réponse du composant électronique 3 au signal électrique SE, doit être captée, le type de grandeur électrique à capter sur la ou les électrodes désignées, au moins un premier délai de stabilisation fixé D1 pour laisser se stabiliser la grandeur électrique à capter après application du signal électrique SE, éventuellement un second délai de mesure fixé D2 pour permettre la stabilisation de la mesure de la grandeur électrique captée GEC, et au moins un domaine de validité pour la grandeur électrique mesurée GEM. L'ensemble des multiplets peut être stocké sous forme d'un fichier de données agencé, par exemple, en base de données.

Ces moyens de test 6 sont connectés à une interface 8, elle-même connectée à des moyens de gestion 9 des électrodes 4. L'interface 8 est pilotée par un séquenceur 10 logé, par exemple, dans les moyens de test 6. Ce séquenceur 10 est destiné à configurer l'interface 8 avec les paramètres contenus dans l'un des multiplets de la mémoire 7. Une fois configurée, l'interface 8 est prête à effectuer un test choisi, correspondant au multiplet de configuration, sur les électrodes désignées par ledit multiplet.

L'appareil de test 2 est géré par un programme informatique PRG stocké dans une mémoire principale 11, laquelle contient en outre des librairies propres au langage informatique utilisé pour l'écriture du programme PRG, par exemple le langage C. Bien entendu, ce programme peut être écrit en tout autre langage informatique.

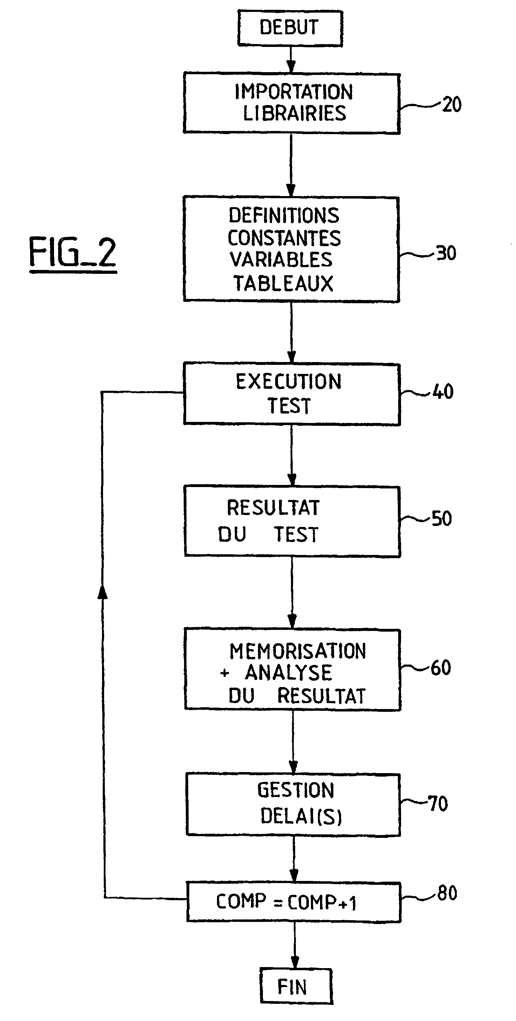

On se réfère maintenant plus particulièrement à la figure 2 pour décrire le mode de fonctionnement général de l'appareil de test 2 de la figure 1.

Le déroulement d'un test, effectué par un appareil de test classique, comprend une succession d'étapes gérées par le séquenceur 10. Au début du test, l'utilisateur appelle le programme PRG, ce qui déclenche l'importation 20 de librairies stockées dans la mémoire principale 11 et nécessaires au bon fonctionnement du programme PRG. Puis l'utilisateur choisit, dans une liste proposée par le programme PRG, le composant électronique qu'il souhaite tester, et éventuellement le type de test si ce choix est offert par le programme PRG. Cette sélection peut également indiquer à l'appareil de test le nombre de composants électroniques du même type que l'utilisateur souhaite tester successivement. Cela constitue l'étape 30 au cours de laquelle le programme, en fonction du composant électronique choisi, définit un certain nombre de paramètres, comme par exemple des constantes, des variables désignant des mots-clés, et des tableaux de données. En fait, dans cette étape 30 (ou a)), on configure le programme PRG avec les paramètres contenus dans le multiplet qui correspond au test choisi, lequel est stocké dans la mémoire 7 des moyens de test 6.

L'exécution proprement dite du test (étape 40 de la figure 2, ou étapes b) à d)) peut alors commencer. On reviendra plus loin sur le détail d'une telle exécution.

Si par exemple le test élémentaire choisi ne comprend que la mesure d'une grandeur électrique GE, alors, à la fin de son exécution, on obtient une grandeur électrique mesurée GEM. Cela constitue l'étape 50 (ou étape e)). Le résultat GEM est mémorisé, par exemple, dans une mémoire auxiliaire 12 des moyens de test 6, puis on procède à l'analyse de ce résultat, ce qui constitue l'étape 60 (ou étape f)). Cette analyse consiste à comparer le résultat GEM au domaine de validité qui lui correspond dans le multiplet de configuration du test effectué. Dans un appareil de test classique, si le résultat GEM appartient au domaine de validité, alors le composant électronique 3 est considéré comme BON. Il est considéré comme MAUVAIS dans le cas contraire. On passe alors à l'étape suivante 70 afin de procéder au test du composant électronique 3 suivant, ou bien de terminer le test dans l'hypothèse où un seul composant électronique devait être testé ou si le test terminé concernait le dernier composant d'une série, ou bien encore d'effectuer un autre test sur le même composant.

En général, l'analyse d'un composant électronique comprend une succession de tests différents formant séquence de test, destinés à tester l'ensemble de ces zones conductrices 5. Or, l'exécution de chaque test comprend une multiplicité d'opérations, qui nécessitent pour certaines le respect de phases d'attente (ou délais) destinées à permettre la stabilisation d'un signal électrique SE appliqué, d'une grandeur électrique GE à capter, ou encore la stabilisation de la mesure de la grandeur électrique captée.

Ces phases d'attente font partie de l'étape 40 de la figure 2. Elles consistent notamment, en les étapes b) et d).

Dans l'étape b) on applique le signal électrique SE (ou les signaux électriques) choisi pour le test, puis on attend pendant un premier délai (ou phase d'attente) de stabilisation fixé D1 correspondant audit test. Bien entendu, lorsque le test consiste à appliquer sensiblement en même temps plusieurs signaux éventuellement différents sur des électrodes différentes, il est possible de prévoir plusieurs premiers délais de stabilisation D1 de durées différentes, ou bien un unique premier délai de stabilisation correspondant au premier délai le plus long. Cette étape b) permet au signal électrique SE de s'établir dans le circuit concerné du composant électronique 3.

Dans l'étape d) optionnelle qui vient après l'étape c) au cours de laquelle on procède à la capture de la (ou les) grandeur(s) électrique(s) GE désignée(s) par le test choisi (cette étape peut consister, par exemple, à fermer le circuit concerné dans le composant électronique ou en d'autres termes à connecter les bornes de sortie en vue de la mesure de la grandeur électrique GE désignée par le test), on peut prévoir une nouvelle phase d'attente appelée second délai de mesure D2 correspondant au test choisi, afin que les moyens de mesure disposent d'un temps suffisant pour effectuer la mesure de la grandeur électrique ainsi désignée. Bien entendu, comme pour le premier délai de stabilisation D1, lorsque plusieurs grandeurs électriques doivent être mesurées, sensiblement en même temps, on peut prévoir, soit une pluralité de seconds délais de mesure D2 respectivement pour chaque grandeur électrique à mesurer, soit le plus long des seconds délais de mesure D2.

Chacune des phases d'attente peut durer quelques millisecondes, voire quelques dizaines de millisecondes. Ces phases d'attente ont des durées qui sont largement surestimées afin d'assurer la qualité du résultat du test.

Or, le demandeur s'est aperçu qu'il était possible, contrairement à l'avis généralement répandu, de réduire par une voie "d'apprentissage" certaines au moins des durées (ou délais) des phases d'attente de chaque test.

Pour ce faire, l'invention prévoit un outil d'aide 1 destiné à être connecté à l'appareil de test 2, afin de prendre le contrôle de certaines au moins de ces étapes de fonctionnement. Dans l'algorithme de la figure 2, cette prise de contrôle est effectuée lors de l'étape 70, comprise entre les étapes 60 et 80, c'est-à-dire après que le séquenceur 10 ait terminé une boucle complète (étapes a) à f)).

L'outil d'aide 1 comprend notamment (voir figure 1) des moyens de traitement 13 destinés à prendre le contrôle des moyens de test 6 de l'appareil de test 2, afin d'effectuer de façon répétitive les étapes b) à e) du séquenceur 10 avec à chaque fois un premier délai de stabilisation D1 et/ou un second délai de mesure D2 de valeur inférieure à la valeur précédente, jusqu'à satisfaction d'un critère de fin prédéterminé tenant compte de la distribution des grandeurs électriques mesurées GEM et mémorisées lors de l'étape 60 (voir figure 2) pour chaque valeur de délai (premier et/ou second) diminuée.

Par ailleurs, les moyens de traitement 13 sont capables, après satisfaction du critère de fin, d'établir de nouvelles valeurs de premier délai de stabilisation ND1 et/ou de second délai de mesure ND2, au plus égales à leurs valeurs initiales D1 et D2, et pour lesquelles la distribution des grandeurs électriquement mesurées GEM, et mémorisées, vérifie selon l'invention une condition choisie de dispersion. Ainsi, l'outil d'aide peut fixer automatiquement, et sans aucune assistance extérieure, un ou plusieurs nouveaux délais de durées inférieures ou égales à leurs valeurs respectives initiales, ce qui permet, dans certains cas, de réduire très notablement la durée des tests, et plus particulièrement lorsque ces tests sont effectués sur de très grandes séries de composants électroniques. On reviendra plus loin sur le mode de prise de contrôle des moyens de test 6 par l'outil d'aide 1.

Etant donné que la réduction progressive des phases d'attente entraîne des variations des valeurs des grandeurs électriques mesurées GEM, il est indispensable, afin de pouvoir vérifier l'appartenance de la grandeur électrique mesurée GEM au domaine de validité qui lui correspond, de disposer d'une fonction permettant de ramener GEM à la valeur qu'elle devrait avoir si les phases d'attente présentaient des durées identiques aux durées initialement prévues.

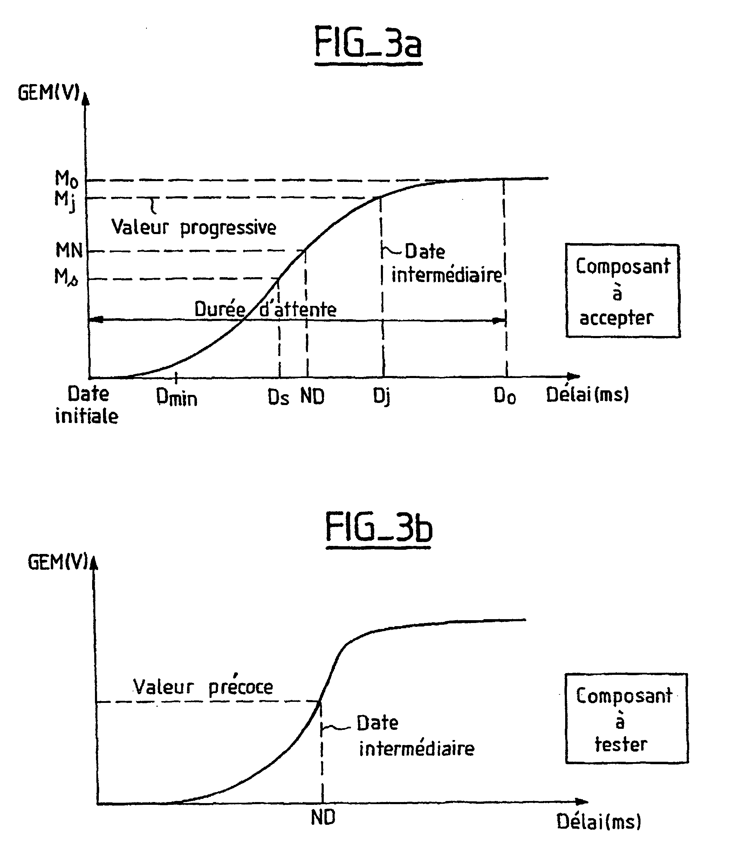

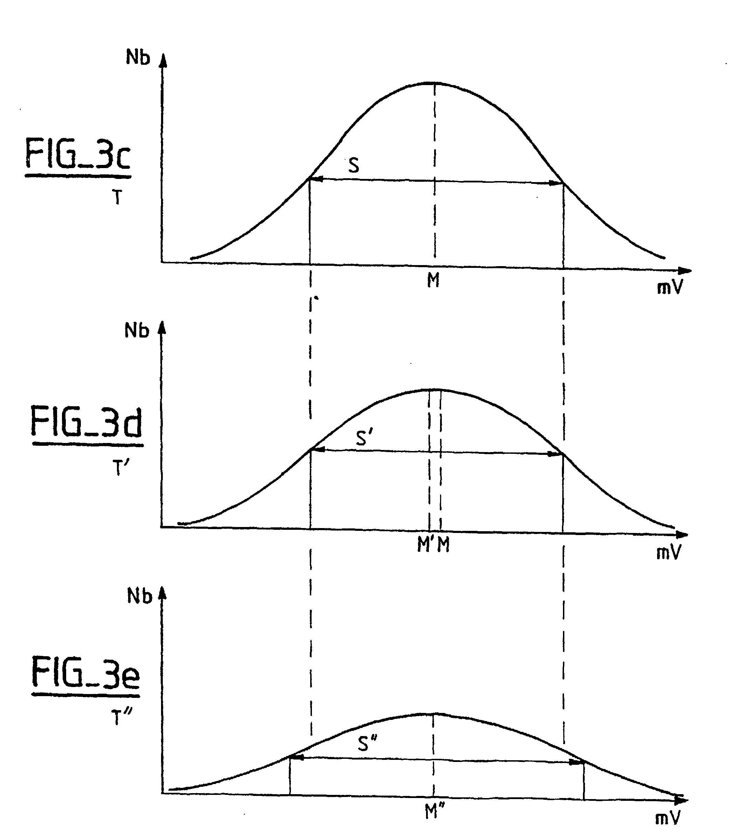

On a représenté sur la figure 3a l'évolution de la valeur d'une grandeur électrique mesurée GEM en fonction du délai d'attente pour effectuer sa mesure. La figure 3a montre l'évolution pour un composant à accepter, dont on sait qu'il est BON. La figure 3b montre l'évolution pour un composant à tester. On considère que la durée d'attente concernée est un délai de mesure D. A un délai de mesure nominal initialement prévu Do, correspond la valeur Mo pour la grandeur électrique mesurée GEM. Cette grandeur électrique peut être par exemple une tension. Lorsque l'on diminue la durée (ou délai) de mesure, la valeur de la grandeur électrique mesurée GEM décroît jusqu'à la valeur 0 pour une durée de délai Dmin supérieure ou égale à 0.

Les figures 3c à 3e montrent une répartition statistique des résultats pour un test donné, à des dates T, T', T" de plus en plus précoces. En ordonnée est représenté le nombre des échantillons pour lesquels la valeur du résultat de mesure a correspondu à une valeur en abscisse. En abscisse sont cotés des mV car dans cet exemple les mesures sont des mesures différentielles de tension: par exemple mesure de différence en un point test de la différence de valeur de tension avec la tension d'alimentation du circuit. On voit schématiquement que la statistique de la figure 3e est très étalée: l'écart type S" est grand.

On peut donc à partir d'une durée nominale T faire les mesures statistiques (de M, S, ou autre) de l'invention à T'=0,95T, à T"=0,9T et ainsi de suite.

En variante, avec un échantillonneur-bloqueur présent dans le circuit de mesure, et des convertisseurs analogique-numériques rapides, on peut acquérir, en une passe, pour chaque échantillon, un historique discret de l'évolution du signal testé lors d'un test. On peut acquérir cet historique pour une population d'échantillon.

Dans tous les cas dans l'invention, on établit alors la statistique des mesures effectuées à chaque date (T, T', T"). Cette statistique est de préférence une mesure de l'écart type. D'autres éléments statistiques sont envisageables. On peut tracer alors une courbe de l'évolution de l'élément statistique mesuré (S, M, ou autre) en fonction du temps T, T', T". Sur la courbe ainsi obtenue, on retient la valeur de date pour laquelle l'élément statistique se trouve dans une proportion donnée de l'élément de base. En résumé, on retient T" quand S" est inférieur à S * (1 + x%), x étant donné ou imposé par les habitudes du fabricant. Dans un exemple x vaut 2.

De même on définit préférentiellement deux autres critères notés CPK1 (low-bas) et CPKh (high-haut). L'expression de ces critères est:

$$CPKl = |\text{moyenne des valeurs - limite basse}|/S$$

$$CPKh = |\text{moyenne des valeurs - limite haute}|/S$$

Les termes entre || sont des termes pris en valeur absolue.

La moyenne des valeurs M est la moyenne des valeurs trouvée à une date donnée T. A une date plus précoce T', les coefficients CPK deviennent

$$CPKl' = |M' - \text{limite basse}|/S'$$

$$CPKh' = |M' - \text{limite haute}|/S'$$

Ainsi, si à la date T la valeur moyenne est 5 volts et si les limites sont 4,5 volts et 5,5 volts pour les limites hautes et basses

$$CPKl \text{ vaut} = 0,5/1 = 0,5$$

$$CPKh \text{ vaut} = 0,5/1 = 0.5.$$

Par contre, à une date plus précoce T', même si S' est encore égale à S (figure 3d), on peut vouloir un critère plus exigent. Il est possible en effet que la valeur M' vaille 4,6 volts. Dans ce cas les coefficients CPK1 et CPKh valent respectivement 0,1 et 0,9. Dans l'invention, avec ce type de critère, d'une part on décide de retenir le plus faible des deux coefficients, le plus défavorable. D'autre part, on décide de fixer comme date T" limite la date à laquelle le coefficient CPK' est dans un rapport donné, ou avec un écart donné du coefficient CPK de base. Par exemple on choisira T", date la plus précoce limite lorsque l'un des CPK aura atteint par rapport à CPK nominal, une excursion limite.

Ces manières de faire présentent alors l'avantage que l'appréciation de la date T" (la plus précoce possible) à laquelle il faut faire les mesures (pour gagner le plus de temps possible pendant le test) est celle pour laquelle la population examinée garde la même homogénéité. Cette manière de faire permet alors de choisir la date T" à retenir en fonction d'un intervalle de confiance connu d'avance. Ceci a pour conséquence un ajustement de la vitesse des tests à un critère de rendement au lieu d'un critère purement technique. Un lot de circuits intégrés testés selon l'invention peut alors être vendu avec la certitude qu'il remplit les mêmes conditions de fiabilité (par exemple une mauvaise pièce jugée bonne toutes les 100 000 pièces) qu'un lot testé selon la méthode ancienne plus longue. L'invention permet donc de quantifier cette exigence de rendement. En pratique, le respect de cette exigence de rendement a un effet technique immédiat sur les utilisations faites de l'appareil de test : ces utilisations sont optimum.

On définit une valeur seuil Ms, figure 3a, en deçà de laquelle la valeur de la grandeur électrique mesurée GEM n'est plus du tout significative. A cette valeur Ms correspond un second délai de mesure Ds. Ainsi, toutes les mesures Mj comprises entre les valeurs Ms et Mo pourront être exploitées par l'outil d'aide 1. Le franchissement de cette valeur seuil Ms par valeur inférieure constitue le critère de fin. Dans un exemple Ms vaut 1 volt. Dans un autre exemple Ms vaut 50% ou un autre pourcentage de Mo.

Le générateur de fonctions 14 a pour but d'élaborer une fonction applicable au domaine de validité et capable de ramener la valeur Mj d'une grandeur électrique mesurée GEM (pour un délai de mesure Dj) à la valeur Mo que cette grandeur électrique mesurée devrait présenter si elle avait été mesurée sur un délai d'une durée égale à Do.

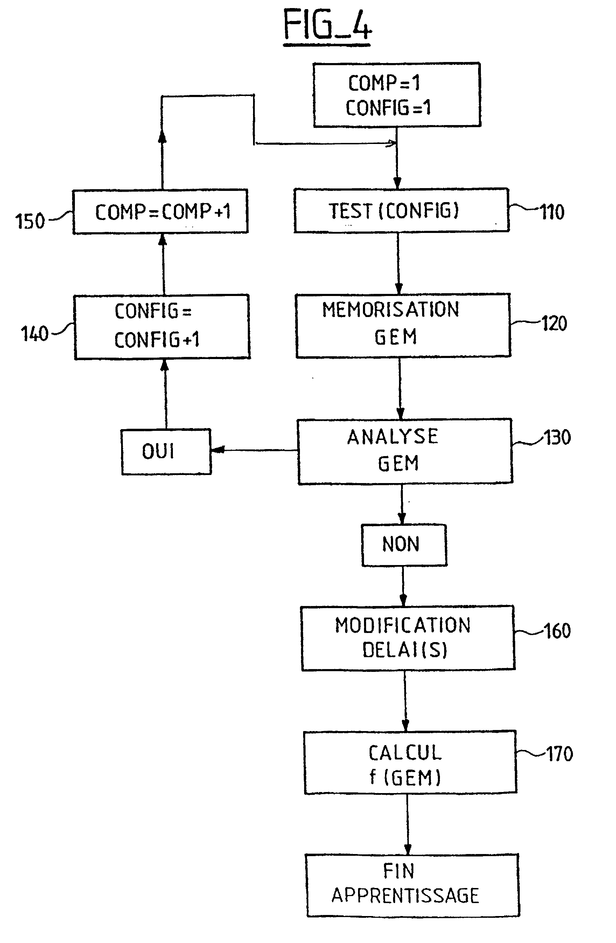

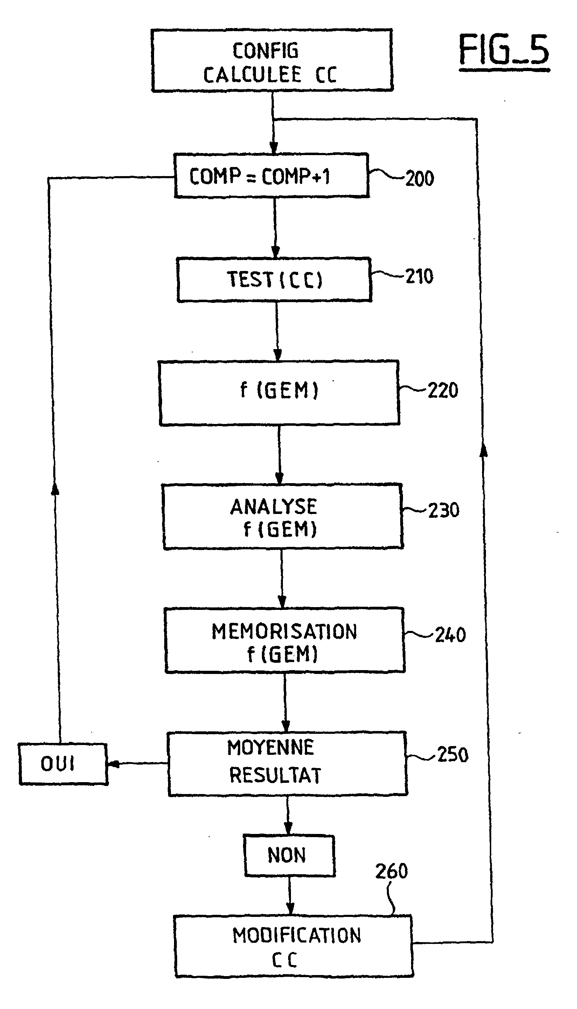

On se réfère maintenant plus particulièrement aux figures 4 et 5 pour décrire en détail un mode de fonctionnement de l'outil d'aide I.

L'outil fonctionne selon deux modes différents : un premier mode dit "d'apprentissage" (figure 3a) au cours duquel il cherche une (ou plusieurs) valeur(s) minimale(s) de durée de phase d'attente pour réduire la durée du test choisi par l'utilisateur de l'appareil de test ; et un second mode (figure 3b), qui vient après le mode d'apprentissage, au cours duquel il "rend la main" au séquenceur 10 afin qu'il effectue les étapes a) à f) avec une nouvelle configuration de délais déterminée lors de l'apprentissage.

Le but de la phase d'apprentissage (voir figure 4) est d'obtenir une courbe de réponse (voir figures 3) de chaque grandeur électrique à mesurer en fonction des durées des phases d'attente.

Pour ce faire, les moyens de traitement 13 comprennent un module d'interception 16 destiné à prendre le contrôle du séquenceur 10 par interception au moins des phases b) à f). Il s'agit en fait d'une interruption dans le déroulement normal du test choisi par l'utilisateur.

Préférentiellement, dans le but de gagner du temps, on effectue la phase d'apprentissage sur un même composant électronique à accepter. Mais, bien entendu, chaque phase d'apprentissage, et en particulier chaque étape de réduction de délai, peut être effectuée sur des composants électroniques successifs. De préférence, lorsque l'apprentissage s'effectue sur un même composant, l'outil d'aide 1 laisse l'appareil de test 2 effectuer une première fois les étapes a) à f) avec les délais initiaux correspondant au test choisi. Dans la suite de la description, on considère que les étapes a) à f) (ou étapes 20 à 60 de la figure 2) constituent une boucle du programme PRG de l'appareil de test 2.

Le séquenceur 10 de l'appareil de test 2 commence alors la seconde boucle en effectuant l'étape a) (configuration de l'interface 8). C'est alors qu'entre en action l'outil d'aide 1, lequel inhibe l'un au moins des premier délai de stabilisation D1 et second délai de mesure D2. Cette opération peut s'effectuer par recherche de mots-clés désignant les délais dans le programme PRG, chargé avec les paramètres du multiplet correspondant au test choisi. En pratique on recherche les instructions "WAIT" qui se trouvent dans ce programme. Ainsi, après ou avant chacun des mots-clés correspondant au délai à modifier, le module d'interception 16 place un ordre d'interruption (dans le langage informatique du programme de l'appareil de test 2), et le remplace par un délai de durée réduite, par exemple Dj (voir figure 3a) supérieur à Ds. La réduction peut être, par exemple, de type pas à pas, ou de type dichotomique. Bien entendu, ces deux modes de réduction ne sont en aucune façon limitatifs. Chaque substitution de délai est éventuellement suivie d'une recompilation du programme PRG.

La seconde boucle du programme PRG peut alors se poursuivre par les étapes b) à e), ce qui constitue l'étape 110 de la figure 4. Puis entre l'étape e) et l'étape f), on effectue une étape 120 au cours de laquelle on mémorise dans une mémoire de travail 17 des moyens de traitement 13 de l'outil d'aide 1 la valeur de la grandeur électrique mesurée lors des étapes précédentes de la boucle en cours. Bien entendu, on pourrait stocker les GEM dans la mémoire auxiliaire 12 de l'appareil de test 2. On compare alors GEM précédemment mémorisé à la valeur seuil Ms prédéfinie, et à laquelle est associé le délai Ds par exemple, qui se trouve mémorisé dans un module de comparaison 18 des moyens de traitement 13. Cela constitue l'étape 130.

Deux cas se présente alors. Soit la valeur de la grandeur électrique mesurée GEM est inférieure à la valeur du seuil Ms, et l'on passe alors directement à une étape 160 décrite plus loin. Soit la valeur de GEM est supérieure à Ms, et dans ce cas, on peut procéder à une nouvelle réduction de la durée du délai. Cette opération est effectuée lors de l'étape 140, au cours de laquelle le module d'interception 16 recherche les ordres d'interruption qu'il a placé précédemment dans le programme PRG afin d'effectuer par un nouveau pas une nouvelle substitution du délai à modifier, ce qui fournit une nouvelle configuration. A ce stade, lorsque la phase d'apprentissage s'effectue sur des composants électroniques successifs, on prévoit une étape 150 où on remplace le composant qui vient d'être testé par le composant suivant.

On recommence alors les étapes 110 à 140 (et éventuellement 150) avec la nouvelle valeur de délai réduite par rapport à sa valeur précédente, jusqu'à ce que la valeur de la grandeur électrique mesurée GEM soit inférieure à la valeur du seuil Ms.

Lorsque tel est le cas, on passe à l'étape 160 au cours de laquelle les moyens de traitement 13 choisissent un délai définitif compris entre le délai initial, ici Do, et le délai Ds correspondant à la valeur seuil Ms. On nomme ce nouveau délai ND et on lui associe la valeur MN de GEM correspondante sur la courbe élaborée point par point par les moyens de traitement 13 à partir des mesures expérimentales effectuées lors des différentes boucles de la phase d'apprentissage.

Ce nouveau délai ND est alors mémorisé dans la mémoire de travail 17 des moyens de traitement 13 qui vont l'insérer aux endroits déterminés lors de la phase initiale de recherche des mots-clés, à la place des arguments qui suivaient les instructions WAIT. Puis, dans une étape 170, le générateur de fonctions 14 de l'outil d'aide 1 élabore la fonction f (GEM) qui devra être appliquée aux grandeurs électriques mesurées GEM sur les composants électroniques à tester ultérieurement afin que leurs valeurs mesurées pour le délai ND soient ramenées à la valeur que la grandeur électrique mesurée devrait présenter si elle était effectuée avec un délai Do tel qu'initialement choisi pour le test. Cette manière de faire n'est nullement indispensable. Elle est utile pour comparer entre eux des tests faits avant et avec l'invention.

On peut prévoir, en variante, des moyens de traitement 13, capables par l'intermédiaire par exemple du module d'interception 16, d'appliquer une fonction inverse à celle choisie f(), afin d'aller modifier le domaine de validité correspondant à la grandeur électrique à mesurer, de sorte que lors des tests suivants, on procède à la comparaison de la valeur de la grandeur électrique mesurée, au nouveau domaine de validité corrigé par la fonction inverse, au lieu d'appliquer la fonction f() élaborée lors de l'étape 170 à cette valeur de la grandeur électrique mesurée pour en effectuer une comparaison au domaine de validité initial.

Tous les couples expérimentaux contenant les mesures GEM calculées lors des boucles successives de la phase d'apprentissage, et le (ou les) délai(s) correspondants, lesquels couples forment la courbe de réponse du composant, sont désormais stockés sous forme d'une table de correspondance dans la mémoire de travail 17 des moyens de traitement 13. Mais ils pourraient également être stockés dans une mémoire prévue à cet effet dans le générateur de fonction 14, ou dans une mémoire de l'appareil de test 2. Les éléments de cette invention, procédé et outil d'aide de test pour appareils de test de composants électriques, peuvent ainsi être stockés dans le programme de test, dans des librairies appelées par le programme de test, dans la mémoire du testeur, dans tout autre support permettant un stockage, ainsi que dans le système d'exploitation du testeur.

Bien entendu, cette table de correspondance peut être formée de triplets, ou plus généralement de multiplets, si la valeur Mj de la grandeur électrique mesurée GEM concernée dépend non seulement d'un premier délai D1j de stabilisation mais également d'un second délai D2j.

La phase d'apprentissage est alors terminée. L'outil d'aide 1 peut alors autoriser l'appareil de test 2 à poursuivre les tests avec le nouveau délai ND déterminé lors de la phase d'apprentissage. L'outil d'aide 1 passe alors dans son second mode de fonctionnement (voir figure 5). Dans ce mode, l'outil d'aide 1 comprend désormais la (ou les) courbe(s) de réponse "théorique(s)" de chacune des grandeurs électriques mesurées GEM des composants électroniques de la série à tester.

Deux sous-modes peuvent être envisagés. Dans un premier sous-mode, l'outil 1 comprend un module 23 capable d'altérer la partie du programme PRG correspondant à la phase f) du séquenceur 10 pour que cette phase opère en permanence avec la fonction f(), c'est-à-dire en appliquant systématiquement f() à chaque valeur GEM avant d'en effectuer la comparaison, ou bien en appliquant la fonction inverse de f() au domaine de validité à comparer au GEM correspondant. L'outil peut alors se mettre "hors service" et laisser le séquenceur 10 travailler sans intervention externe.

Dans un second sous-mode, l'outil 1 autorise le séquenceur 10 à commencer une nouvelle boucle avec la nouvelle configuration CC qui vient d'être calculée, laquelle contient les nouveaux délais, puis on procède au remplacement du composant préalablement testé par le composant suivant, ce qui constitue l'étape 200. On effectue alors dans une étape 210 le test avec la configuration calculée CC, ce qui correspond aux étapes b) à e) du séquenceur 10. Une fois la valeur de la grandeur électrique mesurée GEM obtenue, on lui applique, lors de l'étape 220, la fonction f(), ce qui fournit une valeur f(GEM). Cette valeur f(GEM) est alors analysée dans une étape 230. Cette analyse correspond en fait à l'étape f) du séquenceur 10 puisqu'il s'agit d'une comparaison entre f(GEM) et le domaine de validité qui correspond à la grandeur électrique du test en cours.

Les moyens de traitement 13 de l'outil d'aide 1 peuvent être munis d'un module de filtrage 19 destiné à éliminer des grandeurs électriques mesurées lorsqu'elles sont par trop éloignées du domaine de validité auquel elles doivent être effectuée après l'étape d'analyse 230. Dans cette hypothèse, si la valeur est considérée comme aberrante, on recommence le test en retournant directement à l'étape 210. Dans le cas contraire, on passe à l'étape 240 au cours de laquelle on procède à la mémorisation, par exemple dans une zone 21 de la mémoire de travail 17 des moyens de traitement 13, de f(GEM) préalablement calculée à partir de la valeur GEM mesurée avec le nouveau délai ND2.

Lors de l'étape 230, l'analyse de f(GEM) fournit un résultat indiquant si le composant en cours de test est BON ou MAUVAIS. Dans une étape 250, les moyens de traitement 13 de l'outil d'aide 1 effectuent une moyenne sur l'ensemble des résultats obtenus sur les composants électroniques testés jusqu'alors, en se servant des résultats mémorisés dans la zone 21 de la mémoire de travail 17.

Cette moyenne est alors comparée, par exemple, par le module de comparaison 18 des moyens de traitement 13 à un seuil prédéterminé de rendement. Ainsi, il est possible de déterminer si la série de composants électroniques en cours de test est en dessous ou au-dessus du seuil de rendement fixé par l'utilisateur. Le cas échéant, on ajuste le critère CP' en conséquence.

Les moyens de traitement 13 de l'outil d'aide 1 comprennent un module d'adaptation 22 agencé pour d'une part, effectuer une comparaison entre la moyenne réalisée lors de l'étape 250 par les moyens de traitement 13 et le seuil prédéterminé de rendement, et d'autre part, en fonction de cette comparaison, décider si le nouveau délai modifié ND doit être adapté au seuil de rendement choisi par l'utilisateur. Si tel est le cas, le module d'adaptation 22 établit un nouveau délai modifié NDM supérieur au précédent délai ND déterminé lors de la phase d'apprentissage. Ce délai modifié NDM est alors mis dans le programme PRG, lors de l'étape 260, à la place du précédent délai ND. On retourne alors à l'étape 200, afin de tester le composant électronique suivant. On reproduit alors les étapes 200 à 260 jusqu'à ce qu'il ne reste plus de composant électronique à tester.

Bien entendu, l'étape de modification 260 peut porter sur plusieurs délais, par exemple le premier délai D1 et le premier délai D2, ou bien seulement sur le premier délai D1. On peut envisager une variante de ce second sous-mode, dans laquelle on compare le couple expérimental mesure, qui comprend la valeur Mj et la durée Dj au couple correspondant mémorisé dans la table de correspondance 17 et présentant le même délai D que celui du couple expérimental. Si la valeur de Mj expérimentale est sensiblement identique à la valeur théorique de la grandeur électrique mémorisée dans la table de correspondance 17, alors la fonction du composant électronique testé est considérée comme valide; et par conséquent si seule une grandeur électrique doit être testée sur ce composant électronique, celui-ci est considéré comme BON.

Il est clair que la modification du délai après la phase d'apprentissage peut être adaptée au premier sous-mode décrit ci-avant. Pour ce faire, il suffit qu'après chaque phase f) effectuée par le séquenceur 10, l'outil 1 reprenne la "main" afin d'effectuer une moyenne sur les résultats des composants, moyenne du type de celle décrite en référence au second sous-mode.

Par ailleurs, l'outil d'aide 1 peut être agencé de sorte qu'il réalise, lors de la phase d'apprentissage, une réduction alternée, progressive, du second délai de mesure, lequel peut être plus long que le premier délai de stabilisation, puis de ce premier délai de stabilisation. Dans ce mode de fonctionnement, on procéderait alors comme suit: tout d'abord, dans une première boucle on réduit, par exemple, le second délai D2, puis par une ou plusieurs boucles on modifie le premier délai D1 en conservant le délai D2 modifié jusqu'à ce que le critère de fin soit satisfait (dépassement de la valeur seuil Ms), puis on effectue de nouveau une boucle en réduisant le second délai D2 préalablement modifié, suivie de nouveau par une pluralité de boucles de réduction du premier délai D1 De nombreux autres modes de fonctionnement en combinaison des réductions des délais D1 et D2 peuvent être envisagés.

L'invention ne se limite pas à la forme de réalisation décrite ci-avant, mais elle embrasse toutes les variantes que pourra développer l'homme de l'art dans le cadre des revendications ci-après.

Ainsi, l'agencement des différents modules décrits ci-avant pourra être sensiblement différent de celui décrit, notamment les moyens de traitement et le générateur de fonctions pourraient être réalisés en un unique module (ou composant) électronique multi-fonctionnel. De même, les différentes mémoires pourraient être réalisées sous forme d'une unique mémoire subdivisée en zones ou registres.

Cet outil d'aide pourrait même être intégralement réalisé à l'aide de modules logiciels pouvant être implantés directement dans l'appareil de test. Dans ce cas, il est clair que les modules de mémoires utilisés par cet outil seraient ceux de l'appareil de test.

## Revendications

1. Procédé de test de composants électroniques dans lequel

   - on soumet à une date initiale des électrodes de ces composants à des potentiels électriques,
   - on mesure, à une date (ND) de mesure, des valeurs (MN) de potentiels établis à des bornes de ces composants, et
   - on compare ces valeurs mesurées à des valeurs types, pour accepter ou rejeter les composants en fonction de cette comparaison,

     et, pour la comparaison, dans une phase d'apprentissage préalable,

   - on détermine, à une date nominale (D0) correspondant à une durée nominale d'attente après cette date initiale, pour un lot de composants acceptables et pour un test donné, une image statistique nominale des valeurs mesurées (courbe, figure 3c),

- on détermine pour ce lot acceptable, à au moins une date intermédiaire (Dj), antérieure ou postérieure à la fin de la durée nominale d'attente, une image statistique intermédiaire des valeurs mesurées (courbe, figure 3d),
- **caractérisé en ce que** on choisit une date intermédiaire la plus précoce possible pendant la durée de mesure en comparant, au moyen d'un critère, les images statistiques nominale et intermédiaire des valeurs mesurées, et
- on retient comme date de mesure du test la date intermédiaire la plus précoce possible.

2. Procédé selon la revendication 1, **caractérisé en ce que**

   - l'image statistique déterminée comporte une évaluation de la moyenne (M) des mesures effectuées sur le lot à accepter.

3. Procédé selon l'une des revendications 1 à 2, **caractérisé en ce que**

   - l'image statistique déterminée comporte une évaluation de l'écart type (S) des mesures effectuées sur le lot à accepter.

4. Procédé selon l'une des revendications 1 à 3, **caractérisé en ce que**

   - l'image statistique déterminée comporte une évaluation du rapport d'une première quantité, égale à la valeur absolue de la différence entre la moyenne des mesures effectuées et une limite tolérée pour cette moyenne, à une deuxième quantité, égale à l'écart type des mesures effectuées sur le lot acceptable.

5. Procédé selon l'une des revendications 1 à 4, **caractérisé en ce que**

   - on détermine une image statistique, dite de test, des composants électroniques testés et
   - on modifie ensuite la date de mesure en fonction de la comparaison, au moyen du critère, des images statistiques nominale et de test.

6. Procédé selon l'une des revendications 1 à 5, **caractérisé en ce que**

   - on remplace les valeurs types par des valeurs types intermédiaires (Mj) obtenues par une mesure de valeurs intermédiaires progressives de potentiels qui s'établissent aux bornes des composants, pour un lot de composants acceptables, à une date intermédiaire (Dj), antérieure à la fin de la durée nominale d'attente,
   - on détermine pour ces valeurs intermédiaires des limites intermédiaires, et

- on retient comme bons des composants dont les valeurs mesurées, à la date de mesure sont compatibles avec ces limites intermédiaires.

7. Procédé selon l'une des revendications 1 à 6, **caractérisé en ce que**

   - on remplace les valeurs types par des valeurs types intermédiaires obtenues par un calcul statistique réalisé sur des mesures effectuées à une date intermédiaire sur des composants différents.

8. Procédé selon la revendication 7, **caractérisé en ce que** le calcul statistique comporte un filtrage d'élimination de valeurs aberrantes.

9. Procédé selon la revendication 8, **caractérisé en ce que**

   - le calcul statistique est une moyenne des valeurs mesurées.

10. Procédé selon l'une des revendications 6 à 9 **caractérisé en ce que**

    - on accepte les composants comme bons lorsque les valeurs mesurées sont plus grandes que les valeurs types intermédiaires.

11. Procédé selon l'une des revendications 6 à 9 **caractérisé en ce que**

    - on accepte les composants comme bons lorsque les valeurs mesurées sont plus petites que les valeurs types intermédiaires

12. Procédé selon l'une des revendications 6 à 9 **caractérisé en ce que**

    - on accepte les composants comme bons lorsque les valeurs mesurées sont égales, avec une tolérance donnée, aux valeurs types intermédiaires.

13. Procédé selon l'une des revendications 1 à 12 **caractérisé en ce que**

    - on détermine une date intermédiaire la plus précoce possible en effectuant des itérations du procédé avec un lot de composants acceptables au cours desquelles la date intermédiaire est progressivement éloignée de la fin de la durée nominale d'attente
    - on arrête les itérations lorsque les images statistiques nominale et intermédiaire ne sont plus compatibles selon le critère

**14.** Procédé selon la revendication 13, **caractérisé en ce que**

- la progression de l'éloignement de la date intermédiaire est monotone décroissante.

**15.** Procédé selon l'une des revendications 1 à 14, **caractérisé en ce que**

- les potentiels à mesurer subissant une phase transitoire suivie d'une phase stable, on retient une date intermédiaire située dans la phase transitoire.


**Patentansprüche**

**1.** Testverfahren für elektronische Bauteile, bei dem

- zu einem Anfangszeitpunkt Elektroden dieser Bauteile elektrischen Potentialen unterworfen werden,
- zu einem Meßzeitpunkt (ND) Werte (MN) von Potentialen gemessen werden, die an Klemmen dieser Bauteile erzeugt werden, und
- diese gemessenen Werte mit Standardwerten verglichen werden, um die Bauteile in Abhängigkeit von diesem Vergleich zu akzeptieren oder abzulehnen,

und für den Vergleich, in einer vorhergehenden Lernphase

- zu einem Nennzeitpunkt (D0) entsprechend einer Nennwartezeit nach diesem Anfangszeitpunkt für einen Satz von akzeptablen Bauteilen und für einen gegebenen Test ein statistisches Nennbild der gemessenen Werte bestimmt wird (Kurve, Figur 3c),
- für diesen akzeptablen Satz zu mindestens einem Zwischenzeitpunkt (Dj) vor oder nach dem Ende der Nennwartezeit ein statistisches Zwischenbild der gemessenen Werte (Kurve, Figur 3d) bestimmt wird,

**dadurch gekennzeichnet, daß**

- ein frühstmöglicher Zwischenzeitpunkt während der Meßdauer gewählt wird, indem mittels eines Kriteriums das statistische Nennbild und das statistische Zwischenbild der gemessenen Werte verglichen werden, und
- als Meßzeitpunkt des Tests der frühstmögliche Zwischenzeitpunkt festgelegt wird.

**2.** Verfahren nach Anspruch 1, **dadurch gekennzeichnet, daß** das bestimmte statistische Bild eine Schätzung des Mittelwerts (M) der am zu akzeptierenden Satz durchgeführten Messungen enthält.

**3.** Verfahren nach einem der Ansprüche 1 bis 2, **dadurch gekennzeichnet, daß** das bestimmte statistische Bild eine Schätzung der Standardabweichung (S) der am zu akzeptierenden Satz durchgeführten Messungen enthält.

**4.** Verfahren nach einem der Ansprüche 1 bis 3, **dadurch gekennzeichnet, daß** das bestimmte statistische Bild eine Schätzung des Verhältnisses einer ersten Größe gleich dem Absolutwert der Differenz zwischen dem Mittelwert der durchgeführten Messungen und einem für diesen Mittelwert tolerierten Grenzwert zu einer zweiten Größe gleich der Standardabweichung der am akzeptablen Satz durchgeführten Messungen enthält.

**5.** Verfahren nach einem der Ansprüche 1 bis 4, **dadurch gekennzeichnet, daß**

- ein statistisches Bild, Testbild genannt, der getesteten elektronischen Bauteile bestimmt wird, und
- anschließend der Meßzeitpunkt in Abhängigkeit vom Vergleich, mittels des Kriteriums, des statistischen Nennbilds und des statistischen Testbilds verändert wird.

**6.** Verfahren nach einem der Ansprüche 1 bis 5, **dadurch gekennzeichnet, daß**

- die Standardwerte durch Standardzwischenwerte (Mj) ersetzt werden, die für einen Satz von akzeptablen Bauteilen zu einem Zwischenzeitpunkt (Dj), der vor dem Ende der Nennwartezeit liegt, durch eine Messung von progressiven Zwischenwerten von Potentialen erhalten werden, die an den Klemmen der Bauteile auftreten,
- für diese Zwischenwerte Zwischengrenzwerte bestimmt werden, und
- Bauteile für gut befunden werden, deren gemessene Werte zum Meßzeitpunkt mit diesen Zwischengrenzwerten kompatibel sind.

**7.** Verfahren nach einem der Ansprüche 1 bis 6, **dadurch gekennzeichnet, daß** die Standardwerte durch Standardzwischenwerte ersetzt werden, die durch eine statistische Berechnung erhalten werden, welche an Messungen durchgeführt wird, die zu einem Zwischenzeitpunkt an verschiedenen Bauteilen durchgeführt werden.

**8.** Verfahren nach Anspruch 7, **dadurch gekennzeichnet, daß** die statistische Berechnung eine Filterung zur Eliminierung von abweichenden Werten aufweist.

**9.** Verfahren nach Anspruch 8, **dadurch gekennzeichnet, daß** die statistische Berechnung ein Mittelwert der gemessenen Werte ist.

**10.** Verfahren nach einem der Ansprüche 6 bis 9, **dadurch gekennzeichnet, daß** die Bauteile für gut befunden werden, wenn die gemessenen Werte größer sind als die Standardzwischenwerte.

**11.** Verfahren nach einem der Ansprüche 6 bis 9, **dadurch gekennzeichnet, daß** die Bauteile für gut befunden werden, wenn die gemessenen Werte kleiner sind als die Standardzwischenwerte.

**12.** Verfahren nach einem der Ansprüche 6 bis 9, **dadurch gekennzeichnet, daß** die Bauteile für gut befunden werden, wenn die gemessenen Werte, mit einer gegebenen Toleranz, gleich den Standardzwischenwerten sind.

**13.** Verfahren nach einem der Ansprüche 1 bis 12, **dadurch gekennzeichnet, daß**

- ein frühstmöglicher Zwischenzeitpunkt bestimmt wird, indem mit einem Satz von akzeptablen Bauteilen Iterationen des Verfahrens durchgeführt werden, während denen der Zwischenzeitpunkt progressiv vom Ende der Nennwartezeit entfernt wird,
- die Iterationen beendet werden, wenn das statistische Nennbild und das statistische Zwischenbild nicht mehr gemäß dem Kriterium kompatibel sind.

**14.** Verfahren nach Anspruch 13, **dadurch gekennzeichnet, daß** die Progression der Entfernung des Zwischenzeitpunkts monoton absteigend ist.

**15.** Verfahren nach einem der Ansprüche 1 bis 14, **dadurch gekennzeichnet, daß**, da die zu messenden Potentiale eine Übergangsphase gefolgt von einer stabilen Phase erfahren, ein Zwischenzeitpunkt festgesetzt wird, der sich in der Übergangsphase befindet.

**Claims**

**1.** Method for the testing of electronic components in which:

- electrodes of these components are subjected, at an initial date, to electrical potentials,
- a measurement is made, at a measuring date (ND), of the values (MN) of the potentials set up at terminals of these components, and
- these measured values are compared with typical values in order to accept or reject the components as a function of this comparison,

and for the comparison, in a preliminary learning phase:

- a nominal statistical image of the measured values is determined at a nominal date (D0) corresponding to a nominal waiting duration after this initial date, for a batch of acceptable components and for a given test,
- an intermediate statistical image of the measured values (curve, Figure 3d) is determined for this acceptable batch at least one intermediate date (Dj) prior to or after the end of the nominal waiting duration,

**characterized in that**, the earliest possible intermediate date during the measurement duration is chosen by the comparison, using a criterion, of the nominal and intermediate statistical images of the measured values, and

- the earliest possible intermediate date is chosen as the date of measurement of the test.

**2.** Method according to claim 1, **characterized in that**:

- the determined statistical image comprises an assessment of the mean (M) of the measurements performed on the batch to be accepted.

**3.** Method according to one of the claims 1 to 2, **characterized in that**:

- the determined statistical image comprises an assessment of the standard deviation (S) of the measurements performed on the batch to be accepted.

**4.** Method according to one of the claims 1 to 2, **characterized in that**:

- the determined statistical image comprises an assessment of the ratio between a first quantity, equal to the absolute value of the difference between the mean of the measurements made and a tolerated limit for this mean, and a second quantity, equal to the standard deviation of the measurements made on the acceptable batch.

**5.** Method according to one of the claims 1 to 2, **characterized in that**:

- a statistical image, known as a test image, of the tested electronic components is determined, and
- the date of measurement is then modified as a function of the comparison, by means of the criterion, of the nominal statistical and test images.

6. Method according to one of the claims 1 to 2, **characterized in that**:

   - the typical values are replaced by intermediate typical values (Mj) obtained by a measurement of progressive intermediate values of potentials that are set up at the terminals of the components, for a batch of acceptable components, at an intermediate date (Dj), prior to the end of the nominal waiting period,
   - intermediate limits are determined for these intermediate values, and
   - components whose measured values, at the date of measurement, are compatible with these intermediate limits are chosen as being acceptable.

7. Method according to one of the claims 1, **characterized in that**:

   - the typical values are replaced by intermediate typical values obtained by a statistical computation made on measurements performed at an intermediate date on different components.

8. Method according to claim 7, **characterized in that** the statistical computation is an operation of filtering to eliminate aberrant values.

9. Method according to claim 8, **characterized in that**:

   - the statistical computation is a mean of the measured values.

10. Method according to any of the claims 7 to 9, **characterized in that**:

    - the components are taken to be sound when the measured values are greater than the intermediate type values.

11. Method according to any of the claims 7 to 9, **characterized in that**:

    - the components are accepted as sound when the measured values are smaller than the intermediate type values.

12. Method according to any of the claims 7 to 9, **characterized in that**:

    - the components accepted as sound when the measured values are equal, within a given tolerance, to the intermediate type values.

13. Method according to one of the methods 1, **characterized in that**:

    - an intermediate date that is the earliest possible date is chosen by performing iterations of the method with a batch of acceptable components, during which the intermediate date is progressively moved away from the end of the nominal waiting duration,
    - the iterations are stopped when the nominal and intermediate statistical images are no longer compatible according to the criterion.

14. Method according to claim 13, **characterized in that**:

    - the progress of the moving away of the intermediate date is monotonically decreasing.

15. Method according to one of the claims 1 to 2, **characterized in that**:

    - the potentials to be measured undergoing a transitional phase followed by stable phase, an intermediate phase located in the transitional phase is chosen.

# FIG_1

FIG_2

DEBUT

IMPORTATION
LIBRAIRIES — 20

DEFINITIONS
CONSTANTES
VARIABLES
TABLEAUX — 30

EXECUTION
TEST — 40

RESULTAT
DU TEST — 50

MEMORISATION
+ ANALYSE
DU RESULTAT — 60

GESTION
DELAI(S) — 70

COMP = COMP+1 — 80

FIN

## FIG_3a

GEM(V)

$M_0$
$M_j$

Valeur progressive

MN
$M_\delta$

Durée d'attente

Date intermédiaire

Composant à accepter

Date initiale    $D_{min}$    $D_s$  ND    $D_j$    $D_0$    Délai(ms)

## FIG_3b

GEM(V)

Valeur précoce

Date intermédiaire

Composant à tester

ND    Délai(ms)

17

FIG_3c

FIG_3d

FIG_3e

# FIG_4

```
                                         ┌─────────────┐
                                         │  COMP = 1   │
                                         │ CONFIG = 1  │
                                         └─────────────┘
                                                │
                                                ▼
┌──────────────────┐              ┌──────────────────┐
│  COMP = COMP + 1 │    150       │  TEST (CONFIG)   │    110
└──────────────────┘              └──────────────────┘
                                            │
                                            ▼
┌──────────────────┐              ┌──────────────────┐
│    CONFIG =      │    140       │  MEMORISATION    │    120
│   CONFIG + 1     │              │      GEM         │
└──────────────────┘              └──────────────────┘
                                            │
                                            ▼
         ┌───────┐                ┌──────────────────┐
         │  OUI  │ ◄───────────── │    ANALYSE       │    130
         └───────┘                │      GEM         │
                                  └──────────────────┘
                                            │
                                            ▼
                                       ┌────────┐
                                       │  NON   │
                                       └────────┘
                                            │
                                            ▼
                                  ┌──────────────────┐
                                  │  MODIFICATION    │    160
                                  │    DELAI (S)     │
                                  └──────────────────┘
                                            │
                                            ▼
                                  ┌──────────────────┐
                                  │    CALCUL        │    170
                                  │    f (GEM)       │
                                  └──────────────────┘
                                            │
                                            ▼
                                  ┌──────────────────┐
                                  │      FIN         │
                                  │  APPRENTISSAGE   │
                                  └──────────────────┘
```

FIG_5

```
        ┌──────────────────┐
        │      CONFIG       │
        │   CALCULEE  CC    │
        └──────────────────┘
                 │
                 ▼
        ┌──────────────────┐
        │  COMP = COMP+1    │──── 200
        └──────────────────┘
                 │
                 ▼
        ┌──────────────────┐
        │    TEST (CC)      │──── 210
        └──────────────────┘
                 │
                 ▼
        ┌──────────────────┐
        │     f (GEM)       │──── 220
        └──────────────────┘
                 │
                 ▼
        ┌──────────────────┐
        │     ANALYSE       │──── 230
        │     f (GEM)       │
        └──────────────────┘
                 │
                 ▼
        ┌──────────────────┐
        │   MEMORISATION    │──── 240
        │     f (GEM)       │
        └──────────────────┘
                 │
                 ▼
┌─────┐  ┌──────────────────┐
│ OUI │◄─│     MOYENNE       │──── 250
└─────┘  │    RESULTAT       │
         └──────────────────┘
                 │
                 ▼
            ┌─────────┐
            │   NON   │
            └─────────┘
                 │        260
                 ▼
         ┌──────────────────┐
         │   MODIFICATION    │
         │      C C          │
         └──────────────────┘
```